# EUROPEAN PATENT APPLICATION

(11) **EP 2 602 570 A2**
(43) Date of publication of application: **12.06.2013**
(21) Application number: 12008199.7
(22) Date of filing: 07.12.2012
(51) Int. Cl.: F24J 2/54, F24J 2/14, H01L 31/042, H01L 31/052

(54) **Supporting structure for a parabolic trough of a solar collector**

(30) Priority: 08.12.2011 WO PCT/IB2011/002973
(71) Applicant: NEE Innovations, s.r.o., 60200 Brno (CZ)
(72) Inventor: Rozkydal, Silvestr, 69301 Hustopece (CZ); Tok, Pavel, 61600 Brno (CZ); Cohen, Gilbert, Cary, NC 27519 (US)
(74) Representative: Zemanová, Veronika

(57) **Abstract**

Supporting structure for a parabolic trough of a solar collector, the structure comprising
- a torsion tube (1),
- a first set of arcuate ribs (2) attached to the torsion tube (1), wherein their surfaces forming the inner arcs of the arcuate ribs (2) are arranged substantially along a first concave area,
- a second set of arcuate ribs (2) attached to the torsion tube (1), wherein their surfaces forming the inner arcs of the arcuate ribs (2) are arranged substantially along a second concave area opposing the first concave area, while the intersecting lines of the first and the second concave area with planes perpendicular to the longitudinal axis of the torsion tube (1) form parts of parabolas or circles, having focal points or centres on a line parallel to the longitudinal axis of the torsion tube (1).

The arcuate ribs (2) extend such that a plane going along a side of an arcuate rib (2) through its proximal end and the distal end of the same arcuate rib (2) forms with a plane perpendicular to the longitudinal axis of the torsion tube (1) an angle which is in the range of 10° to 80°, preferably 10° to 30°,

## Description

### Field of the art

The invention relates to a supporting structure for a parabolic through of solar collectors, the supporting structure comprising a torsion tube and diagonal arcuate ribs attached to the torque tube such that they extend along a parabolic or circular concave area.

### Background of the invention

Parabolic trough collectors are generally used in solar power plants. Such collectors comprise a set of elongated reflective troughs having a parabolic cross-section to concentrate radiation of the sun along a focal line extending through the focal points of the parabolic elements of the troughs. A conduit comprising a vacuum insulated tube is positioned along this focal line and a heat transfer fluid is circulated through the tube, where it is heated by the energy of the sun and then it is supplied to generate steam in a power station. As high temperatures, such as e.g. 350 to 400°C, may be achieved, the system is suitable for electricity generation using conventional methods like steam turbine. The parabolic troughs are arranged on a supporting structure and - to increase the efficiency of the collectors - the troughs are provided with tracking systems which allow repositioning of the troughs according to the actual relative position of the sun, such that the parabolic troughs follow the movement of the sun. The parabolic reflective surface of the troughs is provided by means of a plurality of mirrors attached to the supporting structure. In some cases troughs form a circular (cylindrical) surface instead of the parabolic surface.

Various kinds of supporting structures for such parabolic troughs are known in the art; see e.g. WO2010055397 (Ronda), WO2009146215 (Dopp et al.) and US 4,423,719 (Hutchinson). WO2011083197 (Yarza Lorenzo) discloses a supporting structure comprising a mounting tube and set of transversal ribs attached to the mounting tube. The ribs are made of a sheet metal and they are arranged spaced apart and parallel to each other, the sheets extending along planes perpendicular to the longitudinal axis of the mounting tube. A first set of mutually parallel ribs extends from the mounting tube in one direction and a second set of mutually parallel ribs extends from the mounting tube in a second direction, wherein the first set provides a support for mirrors forming a first half of the parabolic (or circular) trough and the second set provides a support for mirrors forming the second (the opposite) half of the parabolic trough. The ribs comprise an arcuate edge, which - in the assembled state of the supporting structure - is to face the rear side of the reflecting mirrors. The arcuate edge should be substantially parabolic or circular to support the reflecting mirrors in positions, in which they form the required reflecting surface of the trough. Usually, the supporting structures comprise also longitudinal elements extending substantially in parallel to the mounting tube and being attached to the ribs connecting those with each other in order to increase rigidity of the supporting structure. The reflecting mirrors may be attached to such longitudinal elements. The solar collectors are usually used in lowlands, especially in deserts, where winds may be very strong. The surface of the reflecting mirrors arranged on the supporting structures is so large that the above supporting structures have to be very strong and rigid - especially regarding their torsion strength - for such harsh conditions. To mitigate or even eliminate risk of damage of the solar collectors induced by strong winds, the number of ribs and longitudinal reinforcing elements has to be rather high. Such case of supporting structures are complicated heavy and its assembling time is long.

### Summary of the invention

Thus the aim of the invention is to improve the above supporting structure to make it less complicated, less heavy and easy to assemble, while providing an excellent stiffness, especially i n torsion.

The aim is achieved with the supporting structure defined in claim 1.

The arcuate ribs are attached to a torsion tube, which is a firm and strong central tube, The torsion tube carries not only the arcuate ribs, but: also the longitudinal elements and in the end also the reflecting mirrors and it has to transfer torque from one collector to the other.

The inner arcuate surfaces of the ribs extend along a parabolic concave area and a plane going along a side of an arcuate rib through its proximal end and its distal end forms with a plane perpendicular to the longitudinal axis of the torsion tube an angle which is in the range of 10° to 80°; preferably 10° to 30°. In other words, in case of sheet metal ribs shown in Figures their centre plane forms with the plane perpendicular to the longitudinal axis of the torsion tube an angle of 10° to 80°, preferably 10° to 30°, most preferably 15°.

Preferably, mutually neighbouring ribs should not be mutually parallel. However, to make the supporting structure simple and easy to assemble, the ribs are preferably arranged such that - in one set of ribs - each rib extends in non parallel with its neighbouring rib, but in parallel with the next one.

Preferably the supporting structure further comprises longitudinal elements for attaching reflecting mirrors, the longitudinal elements being attached to the ribs and extending in parallel to the torsion tube and along the concave areas.

To achieve a high degree of torsion stiffness it is advantageous to arrange the ribs such that the distal end of a rib converges with respect to the distal end of one of its neighbouring ribs and diverges with respect to the distal end of its other neighbouring rib. The ribs arranged at the ends of the supporting structure may be attached to the torsion tube perpendicularly or such that their distal ends diverge with respect the distal end of the only neighbouring rib.

Further preferred embodiments comprise at least one pair of mutually neighbouring ribs arranged such that either their distal ends or their proximal ends abut on each other and are connected with each other by means of a rivet, bolt, screw or weld.

It is also advantageous to arrange the ribs in such a way that each of the ribs has its distal end attached to the distal end of a neighboring rib.

Individual parts of the supporting structure may be made from various suitable materials, that are sufficiently strong and stable. Particularly suitable materials include metal or metal alloys, especially steel, aluminium and aluminium alloys, and composite materials reinforced e.g. with metal, carbon fibres or fiberglass.

The ribs may be riveted, bolted, screwed or welded to the torsion tube,

The expression "arcuate" shall be understood herein not only in its limited meaning but also as describing a polygonal arch.

Although mainly parabolic troughs are discussed herein the supporting structure may be used for circular troughs as well and when referring to "parabolic" shapes, circular shapes are meant as well.

As the ribs are inclined with respect to the plane perpendicular to the longitudinal axis of the torsion tube, they provide a high rigidity for the whole structure, especially the torsion stiffness is excellent and there is no need to add any further slanting or inclined reinforcing rods or to include a very high number of ribs and longitudinal elements. The invention provides a rapid, uniform and efficient installation of supporting structures for parabolic troughs of solar collectors.

### Brief description of the drawings

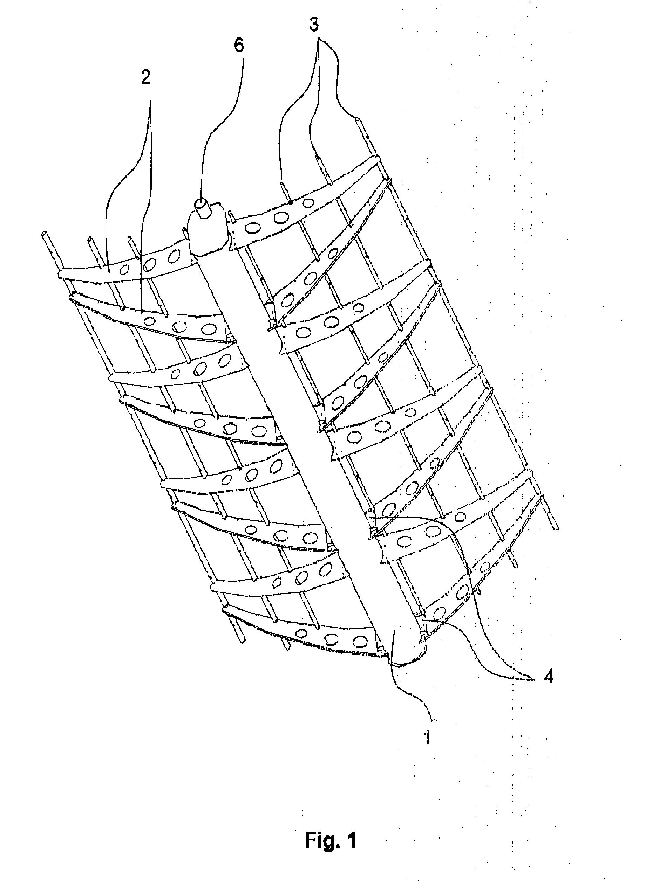

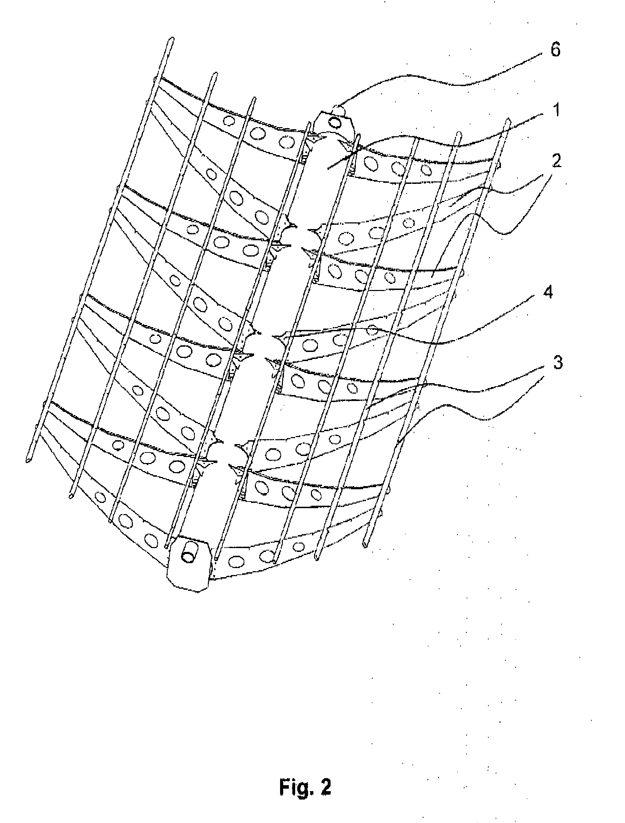

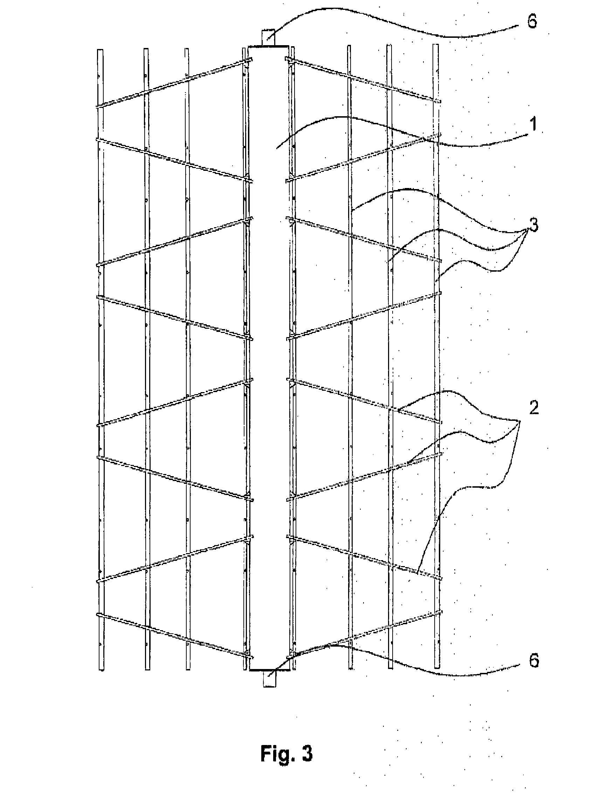

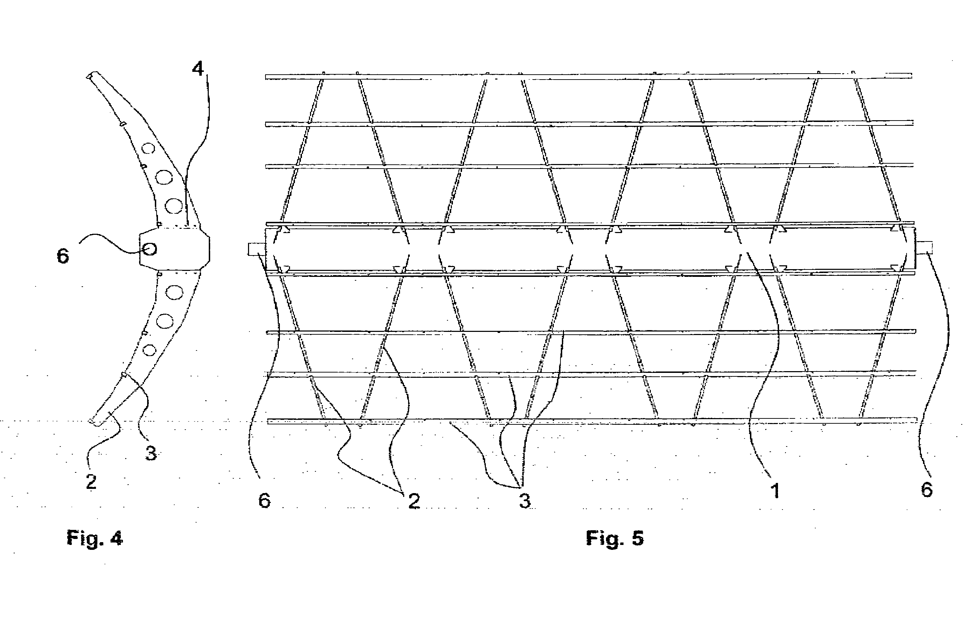

Preferred embodiments of the invention will be further described with reference to the accompanying drawings, wherein Fig. 1 shows an axonometric view of the rear side of a preferred embodiment of the supporting structure; Fig. 2 shows an axonometric view of the front side of the supporting structure of Fig. 1; Fig. 3, 4, and 5 are a bottom view, side view and top view, respectively, of the supporting structure of Fig.1.

### Preferred embodiments of the invention

As shown in the Figures, the supporting structure comprises a torsion tube 1 to which arcuate ribs 2 are attached such that they extend substantially along a parabolic concave area having a focal line parallel to the longitudinal axis of the torsion tube 1. One set of the ribs 2 extends along a first half of the parabolic concave area, the other set along the opposing half of the parabolic concave area. In each set, the arcuate ribs 2 are spaced apart and each of the arcuate ribs 2 is arranged such that its distal end converges with respect to the distal end of one of the neighbouring ribs 2 and diverges with respect to the distal end of the other of the neighbouring ribs 2. It is also possible to arrange the ribs 2 such there are pairs of neighbouring ribs 2 having their proximal ends spaced apart and their distal ends joined together and / or pairs of neighbouring ribs 2 having their proximal ends joined together and their distal ends spaced apart (such embodiment is not shown). Basically, the ribs 2 should be inclined with respect to the torsion tube such that a plane going through the proximal end of an arcuate rib 2 and the distal end of the same arcuate rib 2 forms with a plane perpendicular to the longitudinal axis of the torsion tube 1 an angle which is in the range of 10° to 80°, preferably, 10° to 30°, most preferably 15°; in same cases the range may be 60 to 80, though, The proximal end of each rib 2 comprises a connecting part 4 which is attached to the torsion tube 1 by means of bolts or rivets or combination of both, Other connecting means may also be used.

Several longitudinal elements 3 are attached to the ribs 2 in parallel to the torsion tube 1 and along said parabolic concave area, each of the longitudinal elements 3 being attached to all or at least two arcuate ribs 2 belonging to one set of arcuate ribs 2. The longitudinal elements 3 are adapted to reinforce the supporting structure and to carry the reflecting mirrors of the parabolic trough.

Both ends of the torsion tube 1 are provided with an axle 6, both axles 6 having a common longitudinal axis, which is parallel or identical with the longitudinal axis of the torsion tube 1 and around which the supporting structure rotates when following the movement of the sun.

According to a further embodiment (not shown) the connecting part 4 of a rib 2 may be inclined with respect to the remaining part of the rib 2 such that the rib 2 abuts the torsion tube 1. perpendicularly to the longitudinal axis of the tube 1, while the remaining part of the rib 2 extends along a plane inclined with respect to the longitudinal axis to form the required angle,

The distal ends of the ribs 2 may be inclined or bent with respect to the remaining (intermediate) part of the ribs 2 as well, forming an angle of about 100° to 170°, in that case the ribs 2 are particularly suitable for joining pairs of adjacent distal ends together by a connecting means (not shown)

According to a further embodiment (not shown), the supporting structure may also comprise ribs, especial.ly the end ribs, attached to the torsion tube perpendicularly (as known from prior art), i.e. a plane going through the proximal and distal end of such a rib is substantially perpendicular to the longitudinal axis of the torsion tube.

Although particular embodiments of the present invention have been illustrated and described above, it would be obvious to those skilled in the art that various other changes and moditications can be made without departing from the scope of the present invention, as defined by the appended claims.

## Claims

1. Supporting structure for a parabolic trough of a solar collector, the structure comprising
- a torsion tube (1),
- a first set of arcuate ribs (2) attached to the torsion tube (1), wherein their surfaces forming the inner arcs of the arcuate ribs (2) are arranged substantially along a first concave area,
- a second set of arcuate ribs (2) attached to the torsion tube (1), wherein their surfaces forming the inner arcs of the arcuate ribs (2) are arranged substantially along a second concave area opposing the first concave area, while the intersecting lines of the first and the second concave area with planes perpendicular to the longitudinal axis of the torsion tube (1) form parts of parabolas or circles, having their focal points or centres, respectively, on a line parallel to the longitudinal axis of the torsion tube (1),
**characterised in that**
- the arcuate ribs (2) extend such that a plane going along a side of an arcuate rib (2) through its proximal end and the distal end of the same arcuate rib (2) forms with a plane perpendicular to the longitudinal axis of the torsion tube (1) an angle which is in the range of 10° to 80°.

2. The supporting structure according to claim 1, wherein it further comprises longitudinal elements (3) for attaching reflecting mirrors, the longitudinal elements (3) being attached to the ribs (2) and extending in parallel to the torsion tube (1) and along the concave areas.

3. The supporting structure according to claim 1 ou 2, wherein each rib (2) is arranged such that its distal end converges with respect to the distal end of one of its neighbouring ribs (2) and diverges with respect to the distal end of its other neighbouring rib (2),

4. The supporting structure according to any of the preceding claims wherein at least one pair of mutually neighbouring ribs (2) is arranged such that either their distal ends or their proximal ends abut on each other and are connected with each other by means of a rivet, bolt, screw or weld,

5. The supporting structure according to any of the preceding claims wherein each of the ribs (2) has its distal end attached to the distal end of a neighbouring rib.

6. The supporting structure according to any of the preceding claims wherein arcuate ribs (2) of a set of arcuate ribs (2) extend such that each arcuate rib (2) is non parallel with the neighbouring arcuate rib (2) and at feast one of the arcuate ribs (2) extends in parallel with the next but one arcuate rib (2).

7. The supporting structure according to any of the preceding claims wherein, the arcuate ribs (2) extend such that a plane going along a side of an arcuate rib (2) through its proximal end and the distal end of the same arcuate rib (2) forms with a plane perpendicular to the longitudinal axis of the torsion tube (1) an angle which is i.n the range of 10° to 30°.

8. The supporting structure according to any of the claims 1 to 6 wherein the arcuate ribs (2) extend such that a plane going along a side of an arcuate rib (2) through its proximal end and the distal end of the same arcuate rib (2) forms with a plane perpendicular to the longitudinal axis of the torsion tube (1) an angle which is in the range of 60° to 80°.
